# EUROPEAN PATENT APPLICATION

(11) **EP 4 355 045 A1**
(43) Date of publication of application: **17.04.2024**
(21) Application number: 22201228.8
(22) Date of filing: 13.10.2022
(51) Int. Cl.: H05K 9/00

(54) **SHIELDING ELEMENT FOR ELECTRONIC COMPONENTS**

(71) Applicant: Aptiv Technologies Limited, St. Michael (BB)
(72) Inventor: TALAI, Armin, 90431 Nürnberg (DE); LEONARDI, Roberto, 90403 Nürnberg (DE)
(74) Representative: Bardehle Pagenberg Partnerschaft mbB Patentanwälte Rechtsanwälte

(57) **Abstract**

The present invention relates to a shielding element (10) for electronic components (50), such as electronic components (50) of a radar system, for at least partially shielding electromagnetic energy radiating from the electronic component (50), the shielding element (10) comprising: an inner wall (11), adapted to face the electronic component(s) (50) when assembled, the inner wall (11) comprising a material for at least partially reflecting the electromagnetic energy radiated by the electronic component(s) (50); wherein the inner wall (11) comprises a structure (12), adapted to interfere with the radiated and/or reflected electromagnetic energy (55).

## Description

### Field of the invention

The present invention relates to a shielding element for electronic components, such as electronic components of a radar system. The shielding element is adapted for at least partially shielding electromagnetic energy radiating from the electronic component. The present invention is further related to a respective system for a radar.

### Background

Radar (radio detection and ranging) systems are presently abundantly available and are well known in the art. They are particularly useful for detecting and/or for tracking objects with the help of electromagnetic signals in the regime of radio waves. Radio waves are a type of electromagnetic radiation with the longest wavelengths in the electromagnetic spectrum (typically with frequencies of 300 Gigahertz, GHz, and below). Radar systems are applied in many industrial sectors, for instance in the automotive sector. A particular focus is applied to the microwave spectrum within the radio waves, comprising a type of electromagnetic radiation with a frequency between 300 MHz and 300 GHz. Said frequency corresponds to a wavelength between 1 m and 1 mm. Term radio waves as used herein comprises the regime of microwaves.

Radar systems typically have one or more electronic components which generate and/or receive radio frequency (RF) energy, such as an integrated circuit (IC) or more particularly a Monolithic Microwave Integrated circuit (MMIC). Radar systems may further have an antenna for transmitting and for receiving radio waves. This could also be the same antenna. Additionally, radar systems can have a receiver and processor to determine properties of the objects detected and/or tracked. Radio waves from the antenna are reflected from the objects to be detected and/or tracked and return to the receiver. Thereby, information about the objects can be retrieved.

For accurate detecting and/or tracking, the radio waves transmitted should not be distorted, interfered, or otherwise adversely affected. In particular, it is desired that electromagnetic interference noise is reduced.

The electronic components which generate and/or receive radio frequency can itself radiate electromagnetic energy into their environment. In this manner, the electronic components could influence the radio waves transmitted and/or received, which degrades the performance of the radar system.

Accordingly, there is a need to shield such electronic components from remaining parts of the (e.g. radar) system to increase the performance of said system. The means for shielding should be simple and cost-effective.

In the prior art, attempts have been made to address this need.

For instance, electromagnetic interference (EMI) shields are known. EMI shields may surround or enclose an IC, such as an MMIC of a radar system. However, these known EMI shields typically comprise conductive material, such as metal. This causes a high reflectivity, leading to complex scattering scenarios within the EMI shield. Thus, reflection of electromagnetic energy is enhanced, which causes undesired coupling paths between transmission lines of the MMIC and remaining parts of the radar system, such as other transmission lines and or/ antenna(s). Accordingly, transmitting and receiving of radio waves is interfered, as noise is created.

Other attempts have been made, which rely on more advanced material. For instance, materials are known that can absorb at least partially microwaves. Such materials may also act as thermal absorber materials at the same time. Particularly, materials are known that can at least partially absorb electromagnetic energy in the regime of radio frequency. However, such materials are expensive. Another drawback of these materials is that additional manufacturing steps are required for providing a shield that comprises such a material. In addition, such materials may only be produced by specialized companies, which increases a dependency in the overall manufacturing chain.

In view of the foregoing, the prior art reveals a gap between existing solutions and the above need for shielding elements as posed above. In particular, existing shields fail to reduce noise, to improve the performance of the electronic system and to be cost-effective.

It is thus an object of the present invention to overcome some or all of the deficiencies of the prior art. In particular, it is an object of the invention to provide for an improved shielding element for electronic components, such as electronic components of a radar system. It is a further object of the invention to provide a simplified and cost-effective shielding element, which should be easy to manufacture. The shielding element should be provided with less complex parts and/or materials.

### Summary

The above-mentioned objects are at least partially achieved by the subject-matter of the independent claims. Preferred embodiments are subject of the dependent claims, and the skilled person finds hints for other suitable aspects of the present invention through the overall disclosure of the present application.

An aspect of the invention relates to a shielding element for electronic components, such as electronic components of a radar system, for at least partially shielding electromagnetic energy radiating from the electronic component, the shielding element comprising:
an inner wall, adapted to face the electronic component(s) when assembled, the inner wall comprising a material for at least partially reflecting the electromagnetic energy radiated by the electronic component(s);
wherein the inner wall comprises a structure, adapted to interfere with the radiated and/or reflected electromagnetic energy.

This aspect has the advantage that radiated and/or reflected electromagnetic energy is interfered, and, thereby, impaired to be spread further. Thus, interference with (other) electronic components is substantially prevented. A potential noise generated at (other) electronic components can thus be reduced. If not appropriately shielded as done in conventional solutions, a complex scattering of electromagnetic energy can occur. This is usually expressed as a low isolation of, e.g. at most 34 dB at a frequency of 76.5 GHz, which is not sufficient.

The term "to interfere", "interference" or the like as used herein may be understood in such a way that it (the structure) interposes in a way that substantially hinders and/or impedes something (the electromagnetic energy). Thus, it could mean as to come into collision, e.g. that the structure comes into collision with the electromagnetic energy. Accordingly, the term as used herein is not to be understood as in the term Electromagnetic Interference (EMI), as the latter term describes an adverse effect by way of the interference.

The term "when assembled" means that the shielding element is assembled together with the electronic component(s). Thus, the electronic component(s) are not necessarily comprised by the shielding element, but the shielding element should be suitable to be assembled with the electronic component(s). In one example, the assembling could mean that the shielding element at least partially houses the electronic component(s). Preferably, in the assembled state, the shielding element houses the electronic component(s) completely.

The inner wall, adapted to face the electronic component(s), means that the inner wall could be located at an opposite side and/or a lateral side of the electronic component(s). The inner wall should at least be directed to the electronic component(s) in such a way that electromagnetic energy can be reflected.

As the inner wall comprises a material for at least partially reflecting the electromagnetic energy radiated by the electronic component(s), the electromagnetic energy may be reflected. The material is not particularly limited. The material may comprise conductive material, which is relatively cost-effective and easy to procure. However, also more advanced materials that could already absorb part of electromagnetic energy maybe encompassed.

The structure of the inner wall is not particularly limited and could be any, preferably physical and/or visually recognizable, structure that can interfere with the radiated and/or reflected electromagnetic energy. Thus, the structure can interfere with both, i.e. the electromagnetic energy radiated from the electronic component (directly) and the electromagnetic energy reflected from the inner wall. Preferably, the structure is provided with the intent to interfere with the electromagnetic energy. Thus, fixing means and/or shape variations necessary to a structural integrity of the shielding element are not usually encompassed by the structure.

The term "electronic components"/ "electronic component(s)" as used herein may comprise any kind of electronic component, that is capable of at least partially radiating electromagnetic energy. One electronic component may already be sufficient to be referred to as electronic component(s). Thus, the invention already provides benefits if one electronic component is shielded. Accordingly, the term component(s) is used herein. An example of an electronic component is an integrated circuit (IC), such as a monolithic microwave integrated circuit (MMIC, as described further below). Other examples for an electronic component comprise one or more transmission lines, for instance transmission lines for conducting electromagnetic waves in a substantially contained manner.

The term "transmission line" could mean that the conductor in the line is long enough such that wave phenomena of the transmission should be taken into account. As an example, this could apply to a radio frequency range of about 20 MHz, preferably in the order of magnitude of GHz, such as 1 GHz to about 300 GHz. This may be, because the wavelengths of the radio frequency are relatively short, which means that wave phenomena could arise over a short distance.

Further examples of electronic components maybe: an electrical inverter, a battery, any electronic and/or electrical equipment or the like or any combinations thereof. The electronic components may be part of a system for a radar and/or used in the automotive sector.

The shielding element described herein, if used in a system for a radar, particularly improves the accuracy and performance of the radar in a cost-effective manner.

Preferably, in the shielding element as described herein, the structure covers at least 10%, preferably at least 20%, more preferably at least 30%, more preferably at least 40%, most preferably at least 50% of a surface of the inner wall.

The structure covers at least a certain percentage of a surface of the inner wall. This means that, if e.g. the structure comprises any structural elements, the surfaces of these structural elements would not additionally count to the surface of the inner wall. Thereby, the surface of the inner wall could be regarded as the surface of the inner wall where there is substantially no structure (as for instance in the prior art).

The inventors found that a minimal surface of the inner wall should be covered by the structure as this improves interference with the radiated and/or reflected electromagnetic energy. It was found that after a sufficient surface was covered by the structure, increasing the covering of the surface of the inner wall did not necessarily further improve the isolation and further reduce of noise within the shielding element. Thus, the inventors found that an optimum balance should be struck for covering the surface of the inner wall.

Preferably, in the shielding element as described herein, the structure comprises one or more elongated protrusions and/or recesses, preferably the one or more elongated protrusions and/or recesses having the shape of ridges.

Protrusions may also be understood as a projection and/or something that protrudes from the structure. Preferably, the one or more protrusions is/are directed in such a way that a distance to the electronic component is reduced, when assembled.

It is appreciated that the structure could also comprise recesses. A recess could also be understood as a valley. Preferably, the one or more recesses is/are directed in such a way that a distance to the electronic component is increased, when assembled.

The shape of ridges may be understood in such a way that the one or more protrusions and/or recesses are at least partially tapered and/or conical. In one example, they could have the shape of ribs.

The one or more elongated protrusions and/or recesses have the advantage that interference with electromagnetic energy is further improved. In particular, an incoming electromagnetic energy path could be reflected by at least a part of the one or more elongated protrusions and/or recesses. The reflection could be in such a way that the electromagnetic energy path is substantially reversed. Thus, a scattering (or further transmission) in the incoming direction of the electromagnetic energy path is substantially prevented.

In a preferred embodiment, the one or more elongated protrusions and/or recesses have a cross-section when cut substantially rectangular to a direction of elongation, wherein the cross-section has the shape of a truncated cone, a pyramid, a rectangle, a trapeze, and/or combinations thereof.

The shape of a truncated cone, a pyramid, a rectangle, a trapeze, and/or combinations thereof has the advantage that a greater amount of radiated and/or reflected electromagnetic energy can be interfered. This facilitates to reduce noise and aids that for instance remaining electronic component(s) operate more reliably. As an example, their radio frequency may not be impaired, and any angular error may be reduced. An angular error may be induced if electromagnetic energy is imparted to an electronic component (e.g. a transmission line directed to an antenna), wherein the imparted electromagnetic energy has a different phase coding compared to the radio frequency of the electronic component. Accordingly, the shielding element improves to reduce any angular error.

Preferably, in the shielding element as described herein, the one or more elongated protrusions and/or recesses have a height, respectively a depth of at least 0.2 mm, preferably at least 0.4 mm, more preferably at least 0.6 mm, even more preferably at least 0.8 mm, most preferably of at least 1.0 mm; and/or
wherein the height, respectively the depth is at most 4 mm, preferably at most 3 mm, more preferably at most 2 mm, even more preferably at most 2.5 mm, most preferably at most 1 mm.

The inventors found that the height (respectively depth) of the one or more elongated protrusions and/or recesses should be not too large and not too small.

The height (respectively depth) should be large such that a sufficient interference with the electromagnetic energy is ensured. However, the height (respectively depth) should not be too large, otherwise substantial further improvements may not be achieved but manufacturing costs could increase. Further, if the height (respectively depth) is too large, it might impair different components and or parts that are located in proximity to the shielding element (e.g. inside the shielding element).

Accordingly, the inventors found that an optimum balance should be struck for the height (respectively depth) to provide a compact shielding element, which facilitates sufficient improvement for noise reduction.

The height as used herein may be understood as the distance from a point of the one or more elongated protrusions and/or recesses that is furthest away from the inner wall seen along a straight line that is substantially perpendicular to the inner wall.

Preferably, in the shielding element as described herein, the one or more elongated protrusions and/or recesses have a maximum width parallel to the inner wall of at least 0.2 mm, preferably at least 0.4 mm, more preferably at least 0.6 mm, even more preferably at least 0.8 mm, most preferably of at least 1.0 mm; and/or
wherein the maximum width is at most 4 mm, preferably at most 3 mm, more preferably at most 2 mm, even more preferably at most 2.5 mm, most preferably of at most 1 mm.

The maximum width of the one or more elongated protrusions and/or recesses should be large such that a sufficient interference with the electromagnetic energy is ensured. However, the maximum width should not be too large, otherwise substantial further improvements may not be achieved but manufacturing costs could increase, which is not desired. Further, if the maximum width is too large, it might impair different components and or parts that a located in proximity to the shielding element (e.g. inside the shielding element).

Accordingly, an optimum balance should be struck for the maximum width to provide a compact shielding element, which facilitates sufficient improvement for noise reduction.

Preferably, in the shielding element as described herein, the one or more elongated protrusions and/or recesses are distributed equidistantly on the inner wall.

The maximum width as used herein may be understood as the maximum width of a cross-section when cut substantially rectangular to a direction of elongation of the one or more elongated protrusions and/or recesses. If the cross-section has a tampered shaped, the maximum width may be arranged in near proximity to the inner wall.

Preferably, in the shielding element as described herein, the one or more elongated protrusions and/or recesses are arranged in a curved and/or zig-zag shape on the inner wall.

This specified shape may be regarded as such a shape when seen from a frontal view of the inner wall. Thus, as an example, the zig-zag shape means that the one or more elongated protrusions and/or recesses alternate their direction substantially parallel to the inner wall by a consecutive arrangement of a substantial straight line and a substantial sharp corner.

This has the advantage that the interference with the electromagnetic energy can be controlled in a better way. I.e. it could be possible to manufacture a certain shape to specifically aim at a certain amount of isolation that the shielding element should provide. This may, in one example, depend on the electronic component(s) to be shielded.

In a preferred embodiment, in the shielding element as described herein, at least part of the structure is adapted to be arranged substantially opposite to and facing the electronic component(s) when assembled.

The structure being opposite to and facing the electronic component(s) has the advantage that the structure is arranged at a meaningful location of the inner wall. Thereby, it improves the interference with electromagnetic energy.

In one example, the structure could be adapted to be arranged solely opposite to and facing the electronic component(s). This may be desired in case only this electronic component(s) is to be shielded. Thus, material may not unnecessarily be wasted.

In a preferred embodiment, in the shielding element as described herein, the inner wall comprises a thermal region arranged to be in thermal contact with the electronic component(s) when assembled.

The thermal region as used herein may be understood as a region that is able to act as a heat sink. Thus, heat produced by electronic component(s) can be advantageously absorbed. As an example, the thermal region may be provided as a recess (one could also say that it has the appearance of a dome), which could be larger than the previously described one or more elongated recesses of the structure. A thermal connection of the shielding element to the electronic component(s), such as an IC can thus be established by way of the thermal region. Accordingly, the IC may be cooled, when assembled.

In one example, the thermal region may be provided with a surface roughness, such as to improve a connection of a material applied on the thermal region. This material could be a thermal interface material.

It is appreciated that said surface roughness also improves interference with the electromagnetic energy. Thereby, a noise is advantageously reduced. In one example, the surface roughness could alternatively or additionally be provided on the structure. Preferably, the surface roughness could be provided on the one or more elongated protrusions and/or recesses. In another example, the surface roughness could be provided solely on the inner wall at which substantially no structure is present (e.g. on the thermal region). Overall this improves to reduce a scattering of electromagnetic energy as described herein.

The surface roughness may be substantially smaller compared to the one or more elongated protrusions and/or recesses. Preferably, the surface roughness may have a dimension, which is small than about 0.1 times a wavelength of the electromagnetic energy.

In an example, the one or more elongated protrusions and/or recess are not provided on the thermal region.

Preferably, in the shielding element as described herein, at least part of the structure is integral with the shielding element and/or at least part of the structure is provided as a separate piece.

It is appreciated that the structure could be formed as substantially one piece with the inner wall and/or the shielding element. This significantly improves manufacturing costs. As an example, the structure could be manufactured by a stamping process. The provision as a separate piece has the advantage that more advanced shapes of the structure may be provided relatively simply.

Preferably, in the shielding element as described herein, the shielding element does not comprise absorber material,
wherein the absorber material is defined as a material adapted to attenuate electromagnetic energy of at least 10 dB/cm, preferably at least 20°dB/cm, most preferably at least 30°dB/cm at a frequency of the electromagnetic energy in the range from 2 GHz to 120 GHz, preferably from 10 GHz to 100 GHz, more preferably from 40 GHz to 95 GHz, more preferably from 60 GHz to 90 GHz, more preferably from 70 GHz to 85 GHz, most preferably from 76 GHz to 81 GHz, preferably when measured by insertion loss on an absorber material thickness of 0.5 cm to 1.5 cm, preferably 0.9 cm to 1.1 cm.

This facilitates that cheaper material and in particular conventional materials may be used. As an example, a conductive material such as a metal could be applied. Thus, it is not necessarily required to apply expensive materials, such as Radio Frequency (RF) absorbing materials. Notably, the frequency band of 76 GHz to 81 GHz corresponds to the radar band, which may be applied in the context of the present disclosure.

In one example, the shielding element comprises at least 80%, preferably at least 90%, more preferably at least 95%, most preferably at least 99% metal. The metal could be aluminum, in one example.

Preferably, in the shielding element as described herein, the inner wall comprises an inner top wall and at least four inner side walls substantially rectangular to the inner top wall,
wherein the inner wall forms a substantially hollow portion for at least partially housing the electronic component(s) when assembled,
wherein the structure is arranged on the inner top wall and not on the at least four inner side walls,
wherein the shielding element has an outer shape of a cuboid.

The shape of the cuboid could be such that a length and a width are substantially larger than a height of the cuboid. In this regard, the height could be the height seen in the direction of the top inner wall to the electronic component(s) when assembled.

A further aspect of the invention is directed to a system for a radar, the system comprising:
a shielding element according to any one of the preceding examples;
electronic component(s), such as an integrated circuit (IC) and/or a transmission line, configured to radiate electromagnetic energy;
wherein the shielding element is arranged to at least partially shield electromagnetic energy radiating from the electronic component(s).

As an example, the system may further comprise a first antenna (being a transmitter (Tx) or a receiver (Rx)) and a second antenna (also being a transmitter (Tx) or a receiver (Rx)). Furthermore, the electronic component(s) may comprise an IC and a first transmission line leading to the first antenna and a second transmission line leading to the second antenna. In addition, there may be a different phase coding of the frequency of the first and the second transmission line. Electromagnetic energy may be radiated from the first transmission line and could adversely affect the second transmission line.

Accordingly, the shielding element of the system for a radar is configured to substantially shield (undesired) electromagnetic energy between the first antenna and the second antenna and/or between the first transmission line and the second transmission line.

In a preferred embodiment, in the system for a radar, the shielding element is adapted to have an isolation of at least 35 dB, preferably at least 37 dB, more preferably at least 39 dB, more preferably at least 41 dB, most preferably at least 42 dB, optionally when measured at a frequency of 76.5 GHz.

It may also be possible to achieve the isolation values at a frequency in the range from about 76 GHz to about 81 GHz. This could be the range in which a radar operates (it could also be 76 GHz to 77 GHz).

In one example, there may be an isolation domain with respect to a radar between transmitter (Tx) and receiver (Rx) transmission (or feeding) lines. This domain may demand high isolation. It is appreciated that isolation values of at least 40 dB can be reached.

In another example, there may be an isolation domain with respect to a radar between Rx and Rx transmission lines, and/or between Tx and Tx transmission lines. This domain may not demand such a high isolation. Typically, providing an isolation is difficult, because a distance between Rx and Rx ports and/or between Tx and Tx ports is usually very small.

A particular contribution of the present disclosure is that the aspects described herein are not limited to dedicated shielding elements, but could be applied to substantially any elements that enclose, cover and/or are in vicinity to electronic structures and feeding lines.

It is noted that the features, aspects, embodiments and/or advantages as described herein with reference to the shielding element may likewise be applicable to the system for a radar, even if not expressly described as such but rather with reference to features, aspects, embodiments and/or advantages of the shielding element. It is also to be understood that features, aspects, embodiments and/or advantages described with reference to the system for a radar may equally be applicable to the shielding element.

### Brief description of the figures

In the following, the accompanying figures are briefly described.
- Fig. 1:: illustrates an exemplary shielding element for electronic components according to the prior art in a side cross-sectional view;
- Fig. 2:: illustrates the exemplary shielding element for electronic components according to the prior art of Fig. 1 in a perspective view.
- Fig. 3:: illustrates a shielding element for electronic components according to an embodiment of the invention in a side cross-sectional view;
- Fig. 4:: illustrates a shielding element for electronic components according to an embodiment of the invention in a perspective view.
- Fig. 5:: illustrates a shielding element for electronic components according to a further embodiment of the invention in a perspective view.
- Fig. 6:: illustrates a shielding element for electronic components according to a further embodiment of the invention in a perspective view.
- Fig. 7:: illustrates a shielding element for electronic components according to a further embodiment of the invention in a perspective view.
- Fig. 8:: illustrates a shielding element for electronic components with a thermal region according to a further embodiment of the invention in a perspective view.
- Fig. 9:: illustrates exemplary dimensions of protrusions and recesses comprised by the structure of the inner wall of the shielding element according to embodiments of the invention in a side cross-sectional view.

### Detailed description of the figures

### Definitions

The term Electromagnetic Interference (EMI) may also be termed radio-frequency interference (RFI) when applicable to the radio frequency spectrum. Said EMI is a disturbance generated by, e.g. an external source, that affects an electrical circuit and/or an electronic component by electromagnetic induction, electrostatic coupling, or conduction. The disturbance may degrade the performance of the electrical circuit and/or an electronic component or even stop it from functioning properly.

As used herein, the "noise" may also be understood as coupling path(s), energy transfer line(s) or the like, which adversely affect a desired radio wave to be transmitted, e.g. a radio wave transmitted via one or more transmission lines. Thus, a desired transmission of electromagnetic energy may be impaired by way of the noise.

A "radio wave" is inherently coupled to its radio frequency, as an example, at a (radio) frequency of 300 GHz, the corresponding wavelength (e.g. the length of the radio wave) is 1 mm. At a(radio) frequency of 30 Hz the corresponding wavelength is 10,000 kilometers.

### Figures

In the subsequent passages, the invention is described with reference to the accompanying figures in more detail. It is noted that further embodiments are certainly possible, and the below explanations are provided by way of example only, without limitation.

While specific feature combinations are described in the following with respect to the exemplary embodiments of the present invention, it is to be understood that not all features of the discussed embodiments have to be present for realizing the invention, which is defined by the subject matter of the claims. The disclosed embodiments may be modified by combining certain features of one embodiment with one or more features of another embodiment. Specifically, the skilled person will understand that features, components and/or functional elements of one embodiment can be combined with technically compatible features, components and/or functional elements of any other embodiment of the present invention given that the resulting combination falls within the definition of the invention provided by the claims. The skilled person also understands that certain features may be omitted in so far as they appear dispensable.

Throughout the present figures and specification, the same reference numerals refer to the same elements. The figures may not be to scale, and the relative size, proportions, and depiction of elements in the figures may be exaggerated for clarity, illustration, and convenience.

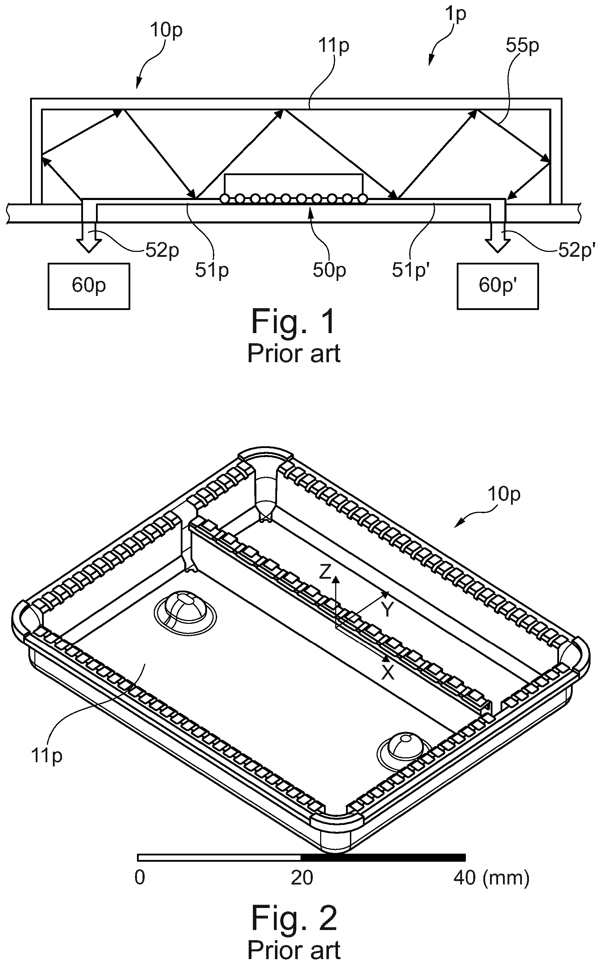

**Fig. 1** shows an exemplary shielding element 10p for electronic components 50p, 51p, 51p', 52p, 52p' according to the prior art. Particularly a system for a radar 1p according to the prior art is shown. The shielding element 10p is facing an integrated circuit (IC) 50p.

A first transmission line 51p and a second transmission line 51p' are shown that pass through a first transition 52p and a second transition 52p', respectively. The first transmission line 51p and the second transmission line 51p' lead to a first antenna 60p and a second antenna 60p' for providing energy, such as electromagnetic energy in the regime of a radio frequency.

The shielding element 10p has an inner wall 11p that is facing the IC 50p, the first transmission line 51p, the second transmission line 51p', the first transition 52p and the second transition 52p'. The shielding element 10p and/or the inner wall 11p are of metal material, which is a conductive material. The inner wall 11p is flat, which facilitates reflection of the energy transfer as indicated by lines 55p.

Fig. 1 further indicates that the energy transfer line 55p is radiated from the IC 50p and/or the transmission lines 51p, 51p' and is reflected several times due to the shielding element 10p, particularly by the inner wall 11p of the shielding element 10p.

This depicted conventional shielding element 10p having such an arrangement of a flat inner wall 11p and a conductive material leads to substantial noise of the system and adversely affects the radar's accuracy of the detection and/or tracking of objects. This is caused by the radiated/reflected electromagnetic energy, as indicate by i.e. the energy transfer line 55p, which influences the different antennas 60p, 60p'. Accordingly, the conventional shielding element 10p leads to a reduced performance of the system for a radar 1p.

**Fig. 2** shows the exemplary shielding element 10p according to the prior art of Fig. 1 in a perspective view. It can be seen that the inner wall 11p is substantially flat, which is disadvantageous as described herein.

The shielding element 10p according to the prior art of Figs. 1 and 2 do not reveal a sufficient isolation. As an example, the isolation would be at most 34 dB at a frequency of 76.5 GHz, which is not sufficient.

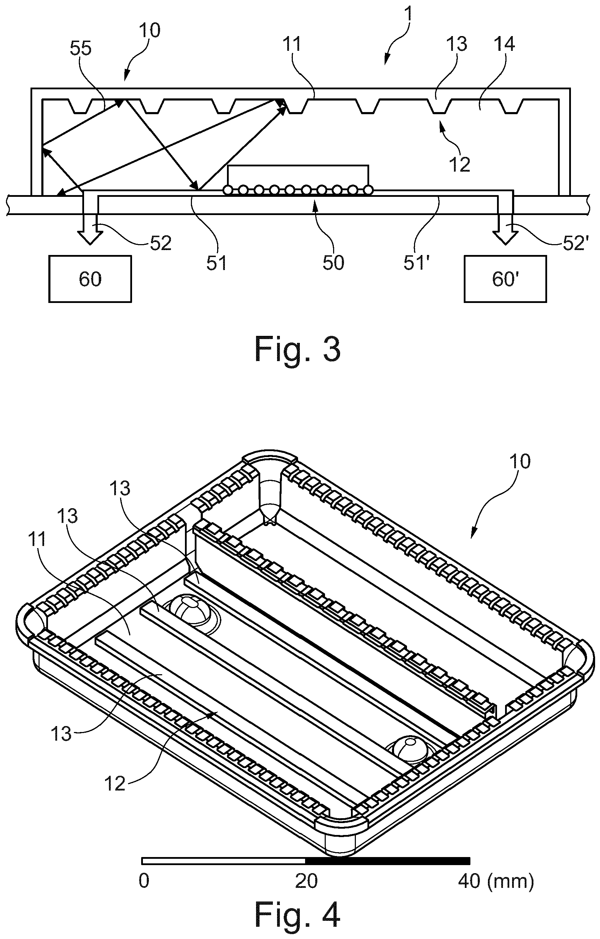

**Fig. 3** shows a shielding element 10 for electronic components 50, 51, 51', 52, 52' according to an embodiment of the invention in a side cross-sectional view.

The description of the reference numerals of Fig. 1 applies in here as well for the reference numerals without the addition of "p". Thus, as an example, the IC 50p of Fig. 1 is similar to the IC of 50 of this figure. Thus, part of the description is left for brevity in here.

Some of the differences to Fig. 1 are explicitly described herein.

The inner wall 11 is adapted to face the electronic component(s) 50, 51, 51', 52, 52' when assembled. The inner wall 11 comprises a material for at least partially reflecting the electromagnetic energy radiated by the electronic component(s) 50, 51, 51', 52, 52'.

The inner wall 11 comprises a structure 12, adapted to interfere with the radiated and/or reflected electromagnetic energy 55. The radiated and/or reflected electromagnetic energy 55 is indicated by the energy transfer line 55.

The radiated and/or reflected electromagnetic energy 55 is prevented from scattering further, e.g. scattering towards another electronic component 50, 51, 51', 52, 52', in particular towards the second transmission line 51' and/or the second transition 52'. Thus, the radio frequency that the second transmission line 51' transmits to the second antenna 60' is not impaired, which is attributable to the structure 12 that interferes with the radiated and/or reflected electromagnetic energy 55.

The structure comprises one or more elongated protrusions 13, only one of which is indicated in this figure. Alternatively or additionally, it may also be possible that the spaces between the one or more protrusions 13 are regarded as one or more elongated recesses 14 (only one of which is indicated).

**Fig. 4** shows a shielding element 10 for electronic components according to an embodiment of the invention in a perspective view. The shielding element has an inner wall 11 comprising a structure 12. The structure has three elongated protrusions 13.

The protrusions 13 have the shape of ridges. Furthermore, the protrusions 13 have a cross-section when cut substantially rectangular to a direction of elongation, wherein the cross-section has the shape of a truncated cone, but it could also be a pyramid, a rectangle, a trapeze etc. This can also be seen in Fig. 3, showing said cross-section more clearly.

The isolation of this shielding element 10 is improved over the shielding element 10p according to the prior art of Figs. 1 and 2. The embodiment of this figure shows an isolation of about at least 39 dB at a frequency of 76.5 GHz, which corresponds to an improvement of about 5 dB.

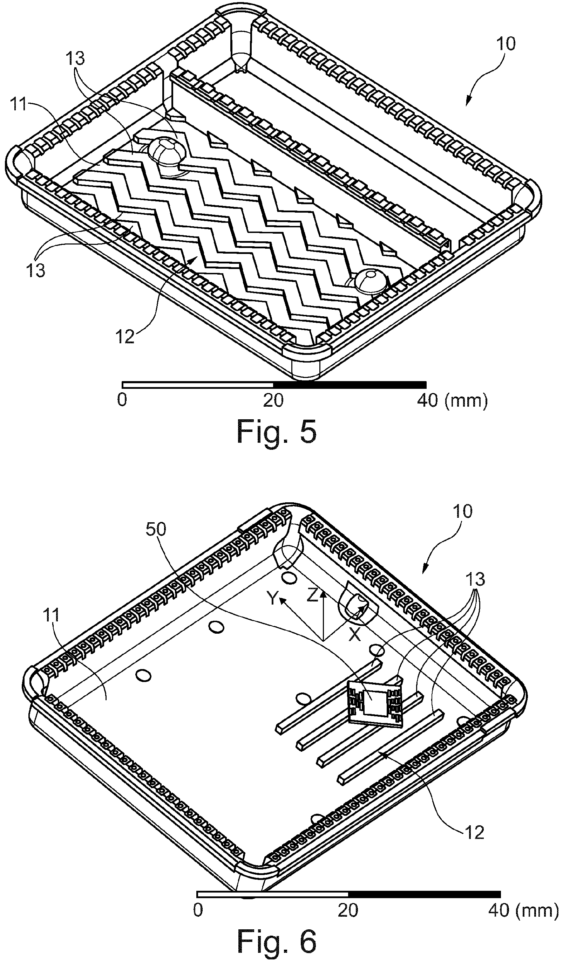

**Fig. 5** shows a shielding element 10 for electronic components according to a further embodiment of the invention in a perspective view.

The shielding element 10 is similar to the one of the preceding embodiment. The one or more elongated protrusions 13 are arranged in a zig-zag shape on the inner wall 11. In this Figure, about five protrusions 13 are shown. However, the fifth protrusion is merely indicated in an upper region of this figure.

In this figure, the structure 12 covers a greater extent of the surface of the inner wall 11 compared to the embodiment of Fig. 4.

The isolation of this shielding element 10 is improved over the shielding element 10p according to the prior art of Figs. 1 and 2. The embodiment of this figure shows an isolation of about at least 41 dB to 42 dB at a frequency of 76.5 GHz, which corresponds to an improvement of about 6 dB to 7 dB.

**Fig. 6** shows a shielding element 10 for electronic components 50 according to a further embodiment of the invention in a perspective view. An IC 50 is also indicated.

The structure 12 is similar to the one of the embodiment of Fig. 4, however, four elongated protrusions 13 are now shown as opposed to three. At least part of the structure 12 is adapted to be arranged substantially opposite to and facing the electronic component 50 when assembled.

In particular, the elongated protrusions 13 are arranged substantially in proximity to the IC. The remainder of the inner wall 11 does not necessarily have to have the structure 12 as an interference with radiated and/or reflected electromagnetic energy may not be necessary in this area.

It may be possible that (preferably a smallest) distance from the structure 12 to the electronic component 50 when assembled is at most 15 mm, preferably at most 10°mm, more preferably at most 8 mm, most preferably at most 5 mm. This could enhance interference with the radiated and/or reflected electromagnetic energy. It may be the case that a lower end limitation of the distance from the structure 12 to the electronic component may be given by mechanical limitations. Such as mechanical limitations due to the stamping process, if the stamping process is applied for providing the structure. It was found that in one example, spacings of about 3 mm show good isolation values.

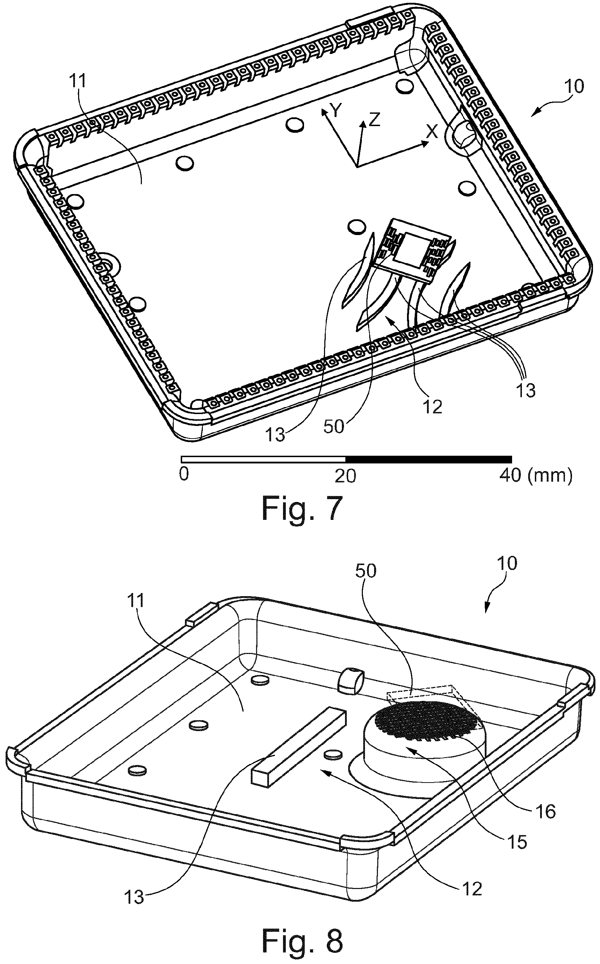

**Fig. 7** shows a shielding element 10 for electronic components 50 according to a further embodiment of the invention in a perspective view.

The shielding element 10 is similar to the one of Fig. 6. The difference to the embodiment of Fig. 6 is that the one or more elongated protrusions 13 are arranged in a curved shape on the inner wall 11. Also in here, four elongated protrusions 13 are shown. At least part of the structure 12 is adapted to be arranged substantially opposite to and facing the electronic component 50 when assembled (as mentioned in the context of the embodiment of Fig. 6).

The following description may not be particularly limited to the embodiment of Fig. 7 as understood by the skilled person: the inner wall 11 comprises an inner top wall and at least four inner side walls substantially rectangular to the inner top wall. The inner wall 11 forms a substantially hollow portion for at least partially housing the electronic component(s) 50 when assembled. The structure 12 is arranged on the inner top wall and preferably not on the at least four inner side walls. The shielding element 10 has an outer shape of a cuboid.

The shape of the cuboid could be such that a length and a width are substantially larger than a height of the cuboid. An exemplary length could be about 60 mm. An exemplary width could be about 40 mm. An exemplary height could be about 5 mm to 10 mm.

**Fig. 8** shows a shielding element 10 for electronic components 50 with a thermal region 15 according to a further embodiment of the invention in a perspective view.

Similar to the preceding embodiments, the shielding element 10 comprises an inner wall 11 comprising a structure 12. Exemplarily, one elongated protrusion 13 is indicated.

The inner wall 11 also comprises a thermal region 15 arranged to be in thermal contact with the electronic component 50 when assembled. The thermal region 15 can act as a heat sink. Thus, heat produced by electronic component 50 can be absorbed. The thermal region 15 is provided as a dome. A thermal connection of the shielding element 10 to the electronic component 50 can thus be established by way of the thermal region 15 and the electronic can be cooled, when assembled.

The thermal region 15 is be provided with a surface roughness 16, to improve a connection of a material applied on the thermal region 15. This material could be a thermal interface material.

The surface roughness 16 could alternatively or additionally be provided on the structure 12. Preferably, the surface roughness 16 could be provided on the one or more elongated protrusions 13 and/or recesses 14.

It is understood that the surface roughness 16 is substantially smaller than the one or more elongated protrusions.

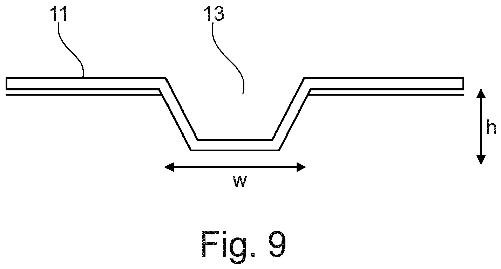

**Fig. 9** shows exemplary dimensions of protrusions 13 comprised by the structure 12 of the inner wall 11 of the shielding element 10 according to embodiments of the invention in a side cross-sectional view.

This should support the understanding of the height, respectively the depth of the one or more elongated protrusions 13 and/or recesses 14 as used herein.

The height (depth) is indicated as "h" and is the distance from a point of the one or more elongated protrusions 13 that is furthest away from the inner wall 11 seen along a straight line that is substantially perpendicular to the inner wall 11.

The maximum width is indicated as "w" and is the maximum width of a cross-section when cut substantially rectangular to a direction of elongation of the one or more elongated protrusions 13, as shown in this figure. These observations apply analogously to recesses.

It is noted that in the above embodiments, the integrated circuit (IC) could be a Monolithic microwave integrated circuit (MMIC). A MMIC is a type of IC that operates at microwave frequencies (e.g. 300 MHz to 300 GHz). MMICs typically perform functions such as microwave mixing, power amplification, low-noise amplification, and high-frequency switching.

It is also noted that the shielding element may comprise first shielding layer and a second shielding layer. The inner wall could be part of the first shielding layer. In one example, the first shielding layer has a thickness of at least 0.2 mm, preferably at least 0.4 mm, more preferably at least 0.6 mm, even more preferably at least 0.8 mm, most preferably of at least 1.0 mm; and/or the first shielding layer has a thickness of at most 10 mm, preferably at most 6 mm, more preferably at most 3 mm, even more preferably at most 2 mm, most preferably of at most 1 mm. Accordingly, the inner wall could have a similar thickness. This has the advantage that the thickness of the inner wall/first shielding layer is sufficient such that the structure can be easily provided to the inner wall.

In a further example the thickness of the second shielding layer is at least ₀.₀₁ mm, preferably at least 0.02 mm, more preferably at least 0.05 mm, even more preferably at least 0.08 mm, most preferably of at least 0.1 mm; and/or the thickness of the second shielding layer is at most 0.8 mm, preferably at most 0.5 mm, more preferably at most 0.2 mm, even more preferably at most 0.15 mm, most preferably of at most 0.1 mm.

Accordingly, the second shielding layer of the shielding element is thinner than the first shielding layer. As an example, the second (thinner) shielding layer is arranged closer to an electronic component when assembled, wherein the second shielding layer has one or more cutouts, such that the structure of the inner wall of the first shielding layer of the shielding element can be easily reached by radiated and/or reflected electromagnetic energy. In case the structure comprises protrusions, the protrusions would protrude through the cutouts.

This facilitates a simplified manufacturing process of the two shielding layers. For instance, the structure could be provided to the first shielding layer, which is thick enough to substantially not break when the structure is provided. As an example, the structure could be provided by a stamping process, which is a cost-effective manufacturing process.

In another example, the structure maybe provided by a molding process, e.g. the shielding could be manufacturing by casting in a mold. In such a case, it is appreciated that substantially no mechanical limitations with regard to materials' thicknesses needs to be taken into consideration.

In all of the embodiments described in the figures, at least part of the structure 12 is integral with the shielding element 10 and/or at least part of the structure 12 is provided as a separate piece, i.e. as a separate piece to the shielding element 10.

It will be apparent to those skilled in the art that numerous modifications and variations of the described examples and embodiments are possible in light of the above teaching. The disclosed examples and embodiments are presented for purposes of illustration only. Other alternate embodiments may include some or all of the features disclosed herein. Therefore, it is the intent to cover all such modifications and alternate embodiments as may come within the true scope of this invention. The scope of protection is determined by the claims and is not limited by the embodiments disclosed in the above figures.

### List of reference signs

- 1p: prior art: system for a radar
- 10p: prior art: shielding element for electronic component(s)
- 11p: prior art: inner wall
- 50p: prior art: integrated circuit
- 5ip: prior art: first transmission line
- 51p': prior art: second transmission line
- 52p: prior art: first transition
- 52p': prior art: second transition
- 55p: prior art: radiated and/or reflected electromagnetic energy, energy transfer line
- 60p: prior art: first antenna
- 60p': prior art: second antenna

- 1: system for a radar
- 10: shielding element for electronic component(s)
- 11: inner wall
- 12: structure
- 13: one or more protrusions
- 14: one or more recesses
- 15: thermal region
- 16: surface roughness
- 50: integrated circuit
- 51: first transmission line
- 51': second transmission line
- 52: first transition
- 52': second transition
- 55: radiated and/or reflected electromagnetic energy, energy transfer line
- 60: first antenna
- 60': second antenna
- w: maximum width of the one or more elongated protrusions and/or recesses
- h: height/depth of the one or more elongated protrusions and/or recesses

## Claims

1. A shielding element (10) for electronic components (50), such as electronic components (50) of a radar system, for at least partially shielding electromagnetic energy radiating from the electronic component (50), the shielding element (10) comprising:
an inner wall (11), adapted to face the electronic component(s) (50) when assembled, the inner wall (11) comprising a material for at least partially reflecting the electromagnetic energy radiated by the electronic component(s) (50);
wherein the inner wall (11) comprises a structure (12), adapted to interfere with the radiated and/or reflected electromagnetic energy (55).

2. The shielding element (10) according to the preceding claim, wherein the structure (12) covers at least 10%, preferably at least 20%, more preferably at least 30%, more preferably at least 40%, most preferably at least 50% of a surface of the inner wall (11).

3. The shielding element (10) according to any one of the preceding claims, wherein the structure (12) comprises one or more elongated protrusions (13) and/or recesses, preferably the one or more elongated protrusions (13) and/or recesses (14) having the shape of ridges.

4. The shielding element (10) according to the preceding claim, wherein the one or more elongated protrusions (13) and/or recesses (14) have a cross-section when cut substantially rectangular to a direction of elongation, wherein the cross-section has the shape of a truncated cone, a pyramid, a rectangle, a trapeze, and/or combinations thereof.

5. The shielding element (10) according to any one of claims 3 or 4, wherein the one or more elongated protrusions (13) and/or recesses (14) have a height, respectively a depth of at least 0.2 mm, preferably at least 0.4 mm, more preferably at least 0.6 mm, even more preferably at least 0.8 mm, most preferably of at least 1.0 mm; and/or
wherein the height, respectively the depth is at most 4 mm, preferably at most 3 mm, more preferably at most 2 mm, even more preferably at most 2.5 mm, most preferably at most 1 mm.

6. The shielding element (10) according to any one of claims 3 to 5, wherein the one or more elongated protrusions (13) and/or recesses (14) have a maximum width parallel to the inner wall (11) of at least 0.2 mm, preferably at least 0.4 mm, more preferably at least 0.6 mm, even more preferably at least 0.8 mm, most preferably of at least 1.0 mm; and/or
wherein the maximum width is at most 4 mm, preferably at most 3 mm, more preferably at most 2 mm, even more preferably at most 2.5 mm, most preferably of at most 1 mm.

7. The shielding element (10) according to any one of claims 3 to 6, wherein the one or more elongated protrusions (13) and/or recesses (14) are distributed equidistantly on the inner wall (11).

8. The shielding element (10) according to any one of claims 3 to 7, wherein the one or more elongated protrusions (13) and/or recesses (14) are arranged in a curved and/or zig-zag shape on the inner wall (11).

9. The shielding element (10) according to any one of the preceding claims, wherein at least part of the structure (12) is adapted to be arranged substantially opposite to and facing the electronic component(s) (50) when assembled.

10. The shielding element (10) according to any one of the preceding claims, wherein the inner wall (11) comprises a thermal region (15) arranged to be in thermal contact with the electronic component(s) (50) when assembled.

11. The shielding element (10) according to any one of the preceding claims, wherein at least part of the structure (12) is integral with the shielding element (10) and/or wherein at least part of the structure (12) is provided as a separate piece.

12. The shielding element (10) according to any one of the preceding claims, wherein the shielding element (10) does not comprise absorber material,
wherein the absorber material is defined as a material adapted to attenuate electromagnetic energy of at least 10 dB/cm, preferably at least 20°dB/cm, most preferably at least 30°dB/cm at a frequency of the electromagnetic energy in the range from 2 GHz to 120 GHz, preferably from 10 GHz to 100 GHz, more preferably from 40 GHz to 95 GHz, more preferably from 60 GHz to 90 GHz, more preferably from 70 GHz to 85 GHz, most preferably from 76 GHz to 81 GHz, preferably when measured by insertion loss on an absorber material thickness of 0.5 cm to 1.5 cm, preferably 0.9 cm to 1.1 cm.

13. The shielding element (10) according to any one of the preceding claims, wherein the inner wall (11) comprises an inner top wall and at least four inner side walls substantially rectangular to the inner top wall,
wherein the inner wall (11) forms a substantially hollow portion for at least partially housing the electronic component(s) (50) when assembled,
wherein the structure (12) is arranged on the inner top wall and not on the at least four inner side walls,
wherein the shielding element (10) has an outer shape of a cuboid.

14. A system for a radar (1), the system (1) comprising:
a shielding element (10) according to any one of the preceding claims;
electronic component(s) (50), such as an integrated circuit (IC) and/or a transmission line, configured to radiate electromagnetic energy;
wherein the shielding element (10) is arranged to at least partially shield electromagnetic energy (55) radiating from the electronic component(s) (50).

15. The system (1) of the preceding claim, wherein the shielding element (10) is adapted to have an isolation of at least 35 dB, preferably at least 37 dB, more preferably at least 39 dB, more preferably at least 41 dB, most preferably at least 42 dB, optionally when measured at a frequency of 76.5 GHz.
